Europäisches Patentamt

European Patent Office

Office européen des brevets

(19)

(11) Publication number: 0 114 402
A2

(12) EUROPEAN PATENT APPLICATION

(21) Application number: 83113145.3

(22) Date of filing: 27.12.83

(51) Int. Cl.³: G 03 F 7/26

(30) Priority: 27.12.82 JP 234654/82

(43) Date of publication of application:
01.08.84 Bulletin 84/31

(84) Designated Contracting States:
DE GB

(71) Applicant: FUJI PHOTO FILM CO., LTD.
210 Nakanuma Minami Ashigara-shi
Kanagawa 250-01(JP)

(72) Inventor: Tezuka, Goro c/o Fuji Photo Film Co. Ltd.
No. 4000, Kawajiri Yoshida-cho
Haibara-gun Shizuoka(JP)

(72) Inventor: Kita, Nobuyuki c/o Fuji Photo Film Co. Ltd.
No. 4000, Kawajiri Yoshida-cho
Haibara-gun Shizuoka(JP)

(74) Representative: Barz, Peter, Dr. et al,
Patentanwälte Dr. V. Schmied-Kowarzik Dipl.-Ing. G.
Dannenberg Dr. P. Weinhold Dr. D. Gudel Dipl.-Ing. S.
Schubert Dr. P. Barz Siegfriedstrasse 8
D-8000 München 40(DE)

(54) Method of developing light-sensitive planographic printing plates and automatic development apparatus.

(57) A method and an apparatus for developing a light-sensitive planographic printing plate is disclosed. The method involves subjecting imagewise exposed light-sensitive planographic printing plates to a developing solution and then collecting and recycling the developing solution which is then used for subjecting more light-sensitive planographic printing plates to the developing solution. The conductivity of the developing solution is continually determined by means of a sensor within the developing solution which is in connection with a meter. When the conductivity of the developing solution reaches a known value water is automatically added to the developing solution in order to maintain the conductivity of the developing solution within a fixed range. The method and apparatus can be advantageously utilized in connection with the use of automatic developing devices in order to continually carry out development of a large number of light-sensitive planographic printing plates.

EP 0 114 402 A2

Croydon Printing Company Ltd.

# METHOD OF DEVELOPING LIGHT-SENSITIVE PLANOGRAPHIC PRINTING PLATES AND AUTOMATIC DEVELOPMENT APPARATUS

The present invention relates to a method of developing light-sensitive planographic printing plates (hereinafter, referred to as PS plate) and, in detail, to a method of developing which comprises supplying diluent to the developing solution to continually maintain the concentration of the developing solution at a value within a fixed range in order to compensate concentrating of the developing solution due to evaporation of water when carrying out development of a number of PS plates by means of an automatic development apparatus, by which uniform development can be carried out, and to an automatic development apparatus for the same.

Generally, when developing PS plates by means of an automatic development apparatus, a supplement solution has been added based on the number of PS plates to be treated and the time required for treatment thereof so that the frequency of exchanging the developing solution accommodated in a development tank of the automatic development apparatus become small even if a large number of PS plates are treated. As the number of PS plates to be treated is increased, effective components in the developing solution accommodated in the development tank are consumed. Accordingly, the developing ability deteriorates and, finally, the desired development can not be carried out. Therefore, in order to compensate for the above described problem, a supplement solution containing the above effective components is added. Further, when using an alkaline developing solution, since the developing solution absorbs carbonic acid gas in the air with the passage of time which deteriorates the developing ability of the developing solution. The above described supplement solution is added to compensate the deterioration. Such methods have been described in British Patent Application 2046931A, Patent Cooperation Treaty Application WO82/C1086 and Japanese Patent Application (OPI) 5045/82, etc. The term "OPI" as used herein means a "published unexamined Japanese Patent Application".

However, if the development of PS plates is carried out with compensation as described above, the developing solution is concentrated by evaporation of water depending upon the temperature and humidity of the environment for development. Consequently, the ability of the solution to dissolve nonimage parts of the light-sensitive layer deteriorates causing inferior development or components composing the light-sensitive layer which are dissolved in the developing solution precipitate in the developing solution causing adhesion of sediments to the printing plates. Therefore, water is previously supplied by hand labor when sediments are formed or when formation of sediments is predicted from experience. However, when using such a method, excess water is often supplied to cause inferior development or the plate to which sediments adhere must be abandoned and produced all over again when water is added due to sediments which are formed.

Accordingly, an object of the present invention is to provide an improved method of developing PS plates, in which problems caused by evaporation of water in the developing solution are solved. More specifically, it is a primary object of the present invention to provide a method of developing PS plates capable of automatically compensating for the evaporation of water in the developing solution and an automatic development apparatus therefor.

As a result of many studies for the purpose of attaining the above object, the present inventors have found that the degree of evaporation of water in the developing solution can be determined by measuring the conductivity of the developing solution. Accordingly, the present invention relates to a method of developing light-sensitive planographic printing plates which comprises developing a number of imagewise exposed light-sensitive planographic printing plates with a developing solution composed of an inorganic ion containing aqueous solution by means of an automatic development apparatus. The method involves measuring the conductivity of the developing solution accommodated in a development tank of the automatic development apparatus, and adding a fixed amount of diluent to said developing solution to continually maintain the concentration of the developing solution at a value within a fixed range when the conductivity reaches a prescribed value which is higher than the initial value of conductivity.

According to the present invention, since the concentration of the developing solution is automatically maintained at a value within a fixed range, stabilized development can be continually carried out without causing the problem of inferior development due to excess supplement of water or formation of sediments due to deficiency of water as prior methods which involved the manual addition of water. Further, since the troublesome work of supplementing the water is not necessary, work efficiency is improved.

0114402

Fig. 1 is a schematic diagram of an automatic development apparatus of the present invention;

Fig. 2 is a schematic diagram of another embodiment of a development apparatus of the present invention; and

Fig. 3 is a graph indicating the relationship between the conductivity of a developing solution and the surface area of PS plates treated while utilizing the method of applicants' invention.

In the present invention, in order to measure conductivity of the developing solution, conventionally used conductometers can be used. More specifically electrode type conductomers and electromagnetic induction type conductometers are advantageously used. It is particularly preferred that such conductometers have a temperature compensating circuit of $\pm 2\%/°C$. One example of useful model of the conductometer comprises a or glass cell of CG-201 PL and a conductometer body CM-30ET produced by Toa Denpa Co. The position where the sensor of the conductometer is set may be suitably decided so long as the sensor is immersed in a developing solution to measure the conductivity of the developing solution when measurement is carried out.

For example, a preferred position is in a developing solution circulating system and, particularly, a development tank, in the automatic development apparatus.

Since the conductivity of the developing solution increases as the developing solution becomes more concentrated, if conductivity of the initial developing solution (namely, fresh developing solution) (hereinafter, referred to as the first conductivity) and conductivity of the concentrated fatigue developing solution at which sediment begin to form (hereinafter, referred to as the second conductivity) are known, it is possible to control the conductivity by adding a fixed amount of the diluent to the developing solution by means of an automatic measuring means such as an automatic measuring pump. The addition of the diluent is carried out when the conductivity reaches a prescribed value which is higher than the first conductivity but lower than the second conductivity. Generally, it is preferred that the above described prescribed value of conductivity is established within 1.3 times of the first conductivity. Further, the amount of the diluent to be supplemented is preferably enough to again provide the first conductivity. This amount can be determined by a simple test if the composition of the developing solution and the amount of it to be fed to the development tank are fixed.

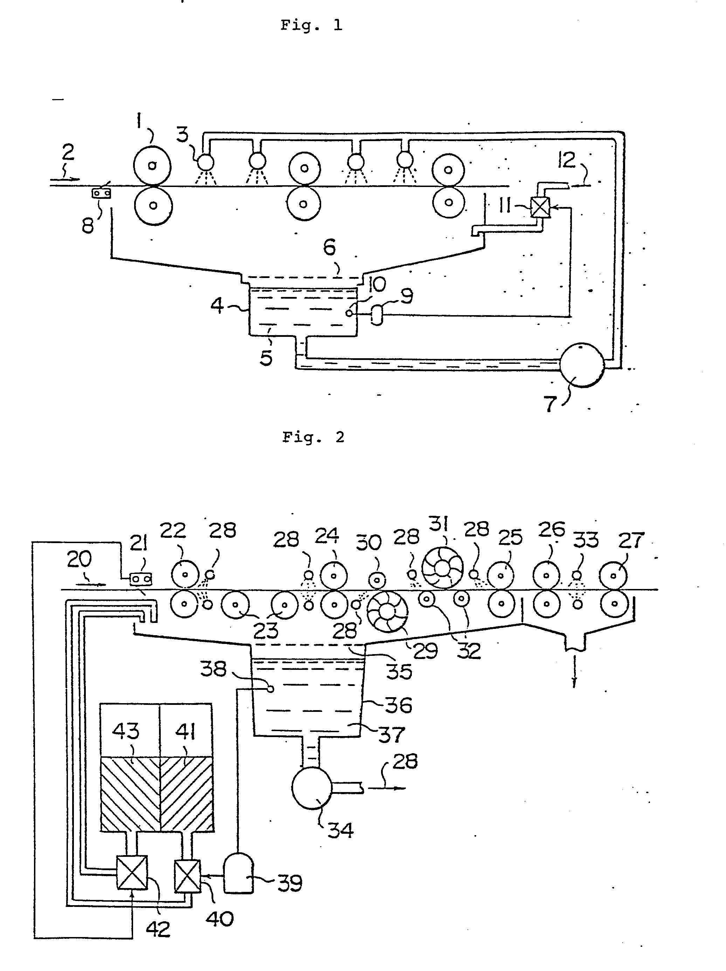

Figure 1 is a schematic section of a particularly preferred embodiment of the automatic development apparatus for carrying out the method of the present invention. In this automatic development apparatus, in the process of conveying PS plates in the direction of the arrow 2 by means of a conveying means such as feed rolls 1, etc., a developing solution 5 in a development tank 4 is sprayed onto the surface of the light-sensitive layer of the PS plates from nozzles of a plurality of nozzle pipes 3 provided over the conveying passage by means of a pump 7 and, if necessary, the surface of the light-sensitive layer is rubbed with a brush roll (not shown in the drawing) to carry out development processing. The used developing solution is recovered in a tank 4 after removal of insoluble substances by means of a filter 6.

When the sensing means 8 detects insertion of the PS plates into the development apparatus, supply of the solution is started by operation of the pump 7, whereby the developing solution begins to spray from the nozzles. When the PS plates pass through the developing zone, spraying of the developing solution is stopped. The conductivity measurement means consists of a conductometer 9 and a sensor 1C. The sensor 1C is installed in a position which is immersed in the developing solution 5 in the tank 4. When the conductivity measured by the conductometer 9 increases to a prescribed value, an automatic measuring means 11 operates by an output signal, by which city water or diluent in a tank 12 is added in a fixed amount to the tank 4. The automatic measuring means 11 is set such that a fixed amount of diluent is added every time the operation signal is received from the conductometer and the addition of diluent is automatically stopped when addition of a fixed amount of diluent is finished. As the automatic measuring means, known means, for example, that which consists of a timer and a liquid sending pump, etc. can be used.

Although the automatic development apparatus shown in Figure 1 is an apparatus which only develops PS plates, it is of course possible to use a PS plate processing apparatus having a development zone, and a cleaning zone, a water wash zone, a gum coating zone and/or a drying zone, in which a diluting means for keeping the concentration of the developing solution within a fixed range as described above is incorporated into the development zone. It is further preferred to incorporate a known means for supplying a development supplement solution into these processing apparatus, because the effect of the present invention is further shown.

Figure 2 is a section of a particularly preferred embodiment of the automatic development apparatus of the present invention, wherein such a supplying means is incorporated. In this apparatus, when PS plates are inserted in the direction of the arrow 20, a detecting means 21 operates and a developing solution 37 in a development tank 36 is sent to a plurality of nozzle pipe 28 provided over and under the conveying passage for the PS plates by means of a pump 34 to start spraying of the developing solution. The PS plates-inserted between insertion rolls 22 are conveyed into a development zone through conveying rolls 23, 24, 30 and 32 while spraying of the developing solution. During the above process, the surface of the light-sensitive layer is rubbed by brush rolls 29 and 31 to completely remove the nonimage parts of the light-sensitive layer, and, finally, the developing solution adhering to the developed PS plates is squeezed out by squeeze rolls 25. Thereafter, they are sent to the water wash zone. The developing solution sprayed is recovered in a tank 36 after insoluble substances are removed by a filter 35. While the sensing means 21 detects the PS plates, an output signal is sent to an automatic measuring means 42, and a development supplement solution 43 is supplied to the developing solution in propertion to the time. Thus, the developing solution which is deteriorated by processing of PS plates is compensated. On the other hand, a conductivity measurement sensor 38 is set up in the developing solution 37 in the development tank 36, and the conductivity of the developing solution 37 is measured by a conductometer 39. When the measured value of the conductometer 39 increases to a prescribed value, an automatic measuring means 40 operates by the output signal of the conductometer and diluent 41 is added in a fixed amount to the developing solution. Thus, concentration of the developing solution by evaporation of water can be conpensated, and it becomes possible to carry out stabilized development over a longer period of time combined with compensation by addition of the development supplement solution.

The plates passed through the development zone are then sent to a water wash zone, where they are sufficiently washed with water. In the water wash zone, insertion rolls 26 and squeeze rolls 27 are set up, and water is sprayed from nozzle pipes 33. The washing water is abandoned directly or it is once recovered in a tank and abandoned after having carried out the required treatment.

In the method of development of the present invention, since the conductivity of the developing solution is measured to detect the concentration thereof, the developing solution used must be an inorganic ion containing aqueous solution and, preferably, an aqueous solution having 70 to 98% by weight of water and containing inorganic ions. Accordingly, the method of the present invention can be advantageously applied to PS plates capable of being developed with such a developing solution.

Preferred examples of such PS plates include PS plates having a light-sensitive layer composed of a diazo resin and a binder having acid groups such as carboxyl groups or alkali soluble groups. As the diazo resins, it is preferred to use substantially water insoluble diazo resins which are soluble in organic solvents, for example, organic sulfonic acid salts of p-diazodiphenylamine-p-formaldehyde condensates described in U.S. Patent 3,300,309, and halogeno Lewis acid salts or perhalogenic acid salts (for example, $BF_4$ salts or $PF_6$ salts) of condensates composed of a diazo compound and a carbonyl containing organic condensating agent, described in Japanese Patent Application (OPI) 98613/79. Useful binder include polyamides, polyethers, polyesters, polycarbonates, polystyrenes, polyurethanes, polyvinyl chloride and copolymers of vinyl chloride, polyvinyl butyral resins, polyvinyl formal resins, shellac, epoxy resins, phenol resins and aoryl resins.

Preferably, there are copolymers of monomers described in the following (1) - (13).

(1) N-(4-hydroxyphenyl)acrylamide, N-(4-hydroxyphenyl)-methacrylamide and N-(4-hydroxynaphthyl)methacrylamide.

(2) o-, m- or p-hydroxystyrene.

(3) o-, m- or p-hydroxyphenyl methacrylate.

(4) Unsaturated carboxylic acids such as acrylic acid, methacrylic acid, maleic acid anhydride or itaconic acid, etc.

(5) Alkyl acrylates such as methyl acrylate, ethyl acrylate, propyl acrylate, butyl acrylate, amyl acrylate, hexyl acrylate, octyl acrylate, 2-chloroethyl acrylate, 2-hydroxyethyl acrylate, glycydyl acrylate or N-dimethylaminoethyl acrylate, etc.

(6) Alkyl methacrylates such as methyl methacrylate, ethyl methacrylate, propyl methacrylate, butyl methacrylate, amyl methacrylate, cyclohexyl methacrylate, 2-hydroxyethyl methacrylate, 4-hydroxybutyl methacrylate, glycidyl methacrylate, N-dimethylaminoethyl methacrylate or benzyl methacrylate, etc.

(7) Acrylamides and methacrylamides such as acrylamide, methacrylamide, N-methylolacrylamide, N-methylolmethacrylamide, N-ethylacrylamide, N-hexylmethacrylamide, N-cyclohexylamide, N-hydroxyethylacrylamide, N-phenylacrylamide, N-nitrophenylacrylamide, or N-ethyl-N-phenylacrylamide, etc.

(8)  Ethyl vinyl ether, 2-chloroethyl vinyl ether, hydroxyethyl vinyl ether, propyl vinyl ether, butyl vinyl ether, octyl vinyl ether and phenyl vinyl ether, etc.

(9)  Vinyl esters such as vinyl acetate, vinyl chloroacetate, vinyl butyrate or vinyl benzoate, etc.

(10)  Styrenes such as styrene, α-methylstyrene, methylstyrene or chloromethylstyrene, etc.

(11)  Vinyl ketones such as methyl vinyl ketone, ethyl vinyl ketone, propyl vinyl ketone or phenyl vinyl ketone, etc.

(12)  Olefins such as ethylene, propylene, isobutylene, butadiene or isoprene, etc.

(13)  N-vinylpyrrolidone, N-vinylcarbazole, 4-vinylpyridine, acrylonitrile and methacrylonitrile, etc.

Further, the above described monomers may be copolymerized with monomers capable of copolymerizing therewith.  Further, copolymers obtained by copolymerizing the above described monomers may be modified with, for example, glycidyl methacrylate or glycidyl acrylate, etc.

Examples of the light-sensitive layer composed of these diazo resins and binders have been described in, for example, U.S. Patents 3,751,257 and 4,123,276 and Japanese Patent Publications 43890/82 and 46772/82, etc.

On the other hand, the developing solution used in the method of the present invention is composed of an inorganic ion containing aqueous solution, as described above, and preferably an aqueous solution having 70 to 90% by weight of water containing inorganic ions. If necessary, it may contain organic solvents, alkali agents, surface active agents and/or other additives.

Preferred inorganic ions include alkali metal ions such as sodium ions potassium ions or lithium ions as well as calcium ions magnesium ions and ammonium ions. As a source of supply, there are anionic surface active agents, alkali agents and sulfites, etc.

Further, in the developing solution is preferably contained a water - softening agent such as ethylenediaminetetraacetic acid, diethylenetriaminepentaacetic acid, triethylenetetraminehexaacetic acid, hydroxyethylethylenediaminetriacetic acid, nitrilotriacetic acid, 1,2-diaminocyclohexanetetraacetic acid, 1,3-diamino-2-propanoltetraacetic acid, the potassium and sodium salts thereof, etc., as is described, for example, in European Patent Application, Publication No. 0080042.

As the above described organic solvents, those which have a solubility in water of 10% by weight or less at a normal temperature are preferably used. Examples of them include carboxylic acid esters such as ethyl acetate, propyl acetate, butyl acetate, amyl acetate, benzyl acetate, ethylene glycol monobutyl ether acetate, butyl lactate or butyl levulinate, etc., ketones such as ethyl butyl ketone, methyl isobutyl ketone or cyclohexanone, etc., and alkohols such as ethylene glycol monobutyl ether, ethylene glycol monobenzyl ether, ethylene glycol monophenyl ether, benzyl alcohol, methyl phenylcarbinol, n-amylalcohol or methyl-amylalcohol, etc. Among them, ethylene glycol monophenyl ether and benzyl alcohol are particularly preferred to use. Such organic solvents are contained in an amount of about 1 to 20% by weight and, preferably, 2 to 10% by weight in the developing solution.

Useful alkali agents include inorganic alkali agents such as sodium silicate, potassium silicate, sodium hydroxide, lithium hydroxide, sodium or ammonium secondary- or tertiary phosphate, sodium methasilicate, etc. and organic alkali agents such as mono-, di- or trimethylamine, mono-, di- or triethylamine, mono- or diisopropylamine, n-butylamine, monoethanolamine, diethanolamine, triethanolamine, monoisopropanolamine, diisopropanolamine, triisopropanolamine, ethyleneimine or ethylenediimine, etc. The organic alkali agents are preferably used. The alkali agents are contained in an amount of about 0.05 to 4% by weight and, preferably, 0.5 to 2% by weight in the developing solution. Anionic surface active agents are preferably used. Examples of them include higher alcohol sulfuric acid ester salts such as sodium salt or ammonium salt of laurylalcohol sulfate or sodium salt or ammonium salt of octylalcohol sulfate, etc., aliphatic alcohol phosphoric acid ester salts such as sodium salt of cetyl alcohol phosphoric acid ester, etc., alkylarylsulfonates such as sodium dodecylbenzenesulfonate, sodium isopropylnaphthalene sulfonate, sodium dinaphthalenesulfonate or sodium metanitrobenzenesulfonate, etc., alkylamidosulfonates such as $C_{17}H_{33}CON(CH_3)CH_2CH_2SO_3Na$, etc., sulfonates of dibasic aliphatic acid esters such as sodium sulfosuccinic acid dioctyl ester or sodium sulfosuccinic acid dihexyl ester, etc., and condensates of alkylnaphthalene sulfonate and formaldehyde such as sodium dibutylnaphthalenesulfonate-formaldehyde condensate, etc. Particularly, those having aromatic sulfonic acid groups are suitable. The surface active agents are contained in an amount of about 0.1 to 10% by weight and, preferably, 0.5 to 5% by weight in the developing solution.

Other additives which may be added to the developing solution include wetting agents such as polyoxyethylene nonylphenyl ether, defoaming agents
and sulfites such as sodium sulfite, etc.

Further details relating to compositions of
the developing solution used for the method of the
present invention have been described in, for example,
U.S. Patents 3,669,660, 3,751,257 and 4,186,006,
British Patents 1,515,174 and 2,068,136, German Patent
Application (OLS) 2,809,774 and Japanese Patent
Applications (OPI) 77401/76, 90602/76, 86328/79, 52054/80,
138740/80, 155355/80 and 70548/81.

The diluent used for the present invention comprises
water or an aqueous solution containing at least one component of the
components contained in the aqueous developing solution
in an amount that the concentration of the component in
the aqueous solution is lower than that in the aqueous
developing solution. The preferable aqueous solution is
obtained by a dilution of the aqueous solution with water
1 to 99 times by volume.

When a large amount of inorganic ionic compounds
is contained in the light-sensitive layer of PS plates
to which the method of the present invention is applied,
inorganic ionic metals in the light-sensitive layer of the
PS plates are eluted into the developing solution.
The increases the conductivity of the developing solution as the number of PS plates treated is increased and at the same time, increase of the conductivity caused by concentration due to evaporation of water in the developing solution occurs. The latter increase of conductivity can not be distinguished from the former increase of conductivity. In such a case, the increase of the conductivity of the developing solution when treating an increased number of PS plates treated is previously estimated. This estimate is fed to a computer so as to detect only increase of the conductivity caused by evaporation of water, by which the diluent supply is controlled such that a fixed amount of diluent is supplied when the conductivity increases to a prescribed value. Of course, it is advantageous that the light-sensitive layer of the PS plates does not contain inorganic ionic metals, so that this troublesome operation will not be required.

With the method of the present invention, it is preferred to use a method of supplying a development supplement solution together, as described in, for example, Japanese Patent Application (OPI) 5045/82.

In the following, the present invention is illustrated in greater detail. Unless otherwise stated, "%" means "% by weight". The scope of the present invention is not limited to these examples.

## EXAMPLE   1

300 g of ethylene glycol monomethyl ether was heated to 100°C under a nitrogen stream, and a mixture composed of 70 g of 2-hydroxyethyl methacrylate, 80 g of acrylonitrile, 130 g of benzyl methacrylate, 20 g of methacrylic acid and 1.2 g of benzoyl peroxide was added dropwise thereto over 2 hours.  After 15 minutes from conclusion of addition, 300 g of ethylene glycol monomethyl ether and 0.3 g of benzoyl peroxide were added to the mixture to carry out reaction for 4 hours.  After conclusion of the reaction, the mixture was diluted with methanol and poured into water to precipitate a copolymer, which was dried at 70°C in vacuum.  The acid value of the resulting 2-hydroxyethyl methacrylate copolymer (I) was 40.2.

A 1S aluminium plate having a thickness of 0.24 mm was degreased by immersing it in a 10% aqueous solution of sodium tertiary phosphate kept at 80°C for 3 minutes.  After being grained by means of a nylon brush, it was desmutted with a 3% aqueous solution of sodium aluminate at 60°C.  The treated aluminium plate was subjected to anodic oxidation in 20% sulfuric acid at a current density of 2 A/dm$^2$ for 2 minutes and, thereafter, it was treated with a 25% aqueous solution of sodium silicate at 70°C for 1 minute.

To the resulting aluminium plate, the following light-sensitive solution was applied and dried at 100°C for 2 minutes to obtain a PS plate.

| | |
|---|---|
| 2-Hydroxyethyl methacrylate copolymer (I) | 87 g |
| 2-Methoxy-4-hydroxy-5-benzoylbenzene-sulfonic acid salt of p-diazodiphenyl-amine-paraformaldehyde condensate | 10 g |
| 50% aqueous solution of phosphorous acid | 3 g |
| Oil Blue #603 (produced by Orient Kagaku Kogyo Co., triphenylmetane oil-soluble dye) | 3 g |
| 2-Methoxyethanol | 600 g |
| Methanol | 600 g |
| Ethylene dichloride | 600 g |

The dry coating amount was 2.0 $g/m^2$. This PS plate was subjected to development processing in a non-exposed state with 1 ℓ of an alkaline aqueous developing solution having the following composition by dish development till 4 $m^2/ℓ$ (The value ($m^2/ℓ$) shows a processing extent represented by surface area ($m^2$) of the processed PS plate based on 1 ℓ of developing solution.)

| | | |
|---|---|---|
| Sodium trinitrilotriacetate | 0.5 | g |
| Sodium sulfite | 3 | g |
| Benzyl alcohol | 30 | g |
| Triethanolamine | 20 | g |
| Monoethanolamine | 5 | g |
| 35% Aqueous solution of sodium t-butyl-naphthalenesulfonate | 30 | g |
| City water | 922 | ml |

In order to reduce the loss of the solution as much as possible when carrying out development, recovery of the solution was attempted by squeezing the surface and the back of the plate after development and, further, the development was rapidly carried out so as not to cause unnecessary evaporation of water in the developing solution in the development process. As a result, the amount of liquid which was 1 ℓ at the start was 0.98 ℓ after conclusion or processing of 4 $m^2/\ell$. Thus a processing solution in which evaporation of water hardly occurred was obtained.

Conductivity of the development processing solution used for processing up to 4 $m^2/\ell$, conductivities of the processing solution used for processing up to 4 $m^2/\ell$ from which 10% and 20% of water were evaporated respectively, and conductivity of a fresh solution for comparison are shown in Table 1. At the same time, the degree of occurrence of development sediments caused by evaporation of water is shown. It is understood from Table 1 that a change of conductivity caused by the development processing is small as compared with a change of conductivity caused by evaporation of the liquid. Thus, the conductivity returned to the value before evaporation when water in an amount corresponding to the amount of evaporation was supplied to the processing solution.

Table 1  Conductivity of Processing Solution and
Occurrence of Development Sediments

| Processing $m^2/\ell$ | Conductivity of processing solution (ms/cm) | | | Occurrence of sediments in processing solution | | |
|---|---|---|---|---|---|---|
| | $0m^2/\ell$ | $2m^2/\ell$ | $4m^2/\ell$ | $0m^2/\ell$ | $2m^2/\ell$ | $4m^2/\ell$ |
| State of evaporation of developing solution | | | | | | |
| (1) Amount of evaporation is nearly 0% | 6.27 | 6.36 | 6.51 | o | o | o |
| (2)      "      10% | | | 7.14 | | | o |
| (3) 10% of water is added to (2) | | | 6.56 | | | o |
| (4) Amount of evaporation is 20% | 7.60 | 7.69 | 7.76 | o | × | ×× |
| (5) 20% of water is added to (4) | 6.32 | 6.39 | 6.50 | o | o | o |

(o: Not occurred,  ×: fairly occurred,  ××: heavily occurred)

In the processing solution concentrated by evaporation, sludges were formed as development sediments which adhered to the plates caused stains.

When water was added in an amount corresponding to the amount of evaporation with stirring, the sludges dissolved and disappeared in the solution.

From the above described result, a conductivity of 7.5 ms/cm was used as a control value.  Using an automatic development apparatus which had such a mechanism that a fixed amount of water is automatically supplied when the conductivity was above the above described value, a number of plates were subjected to development processing. Namely, 10 ℓ of the above described developing solution was put in the development tank of the automatic development apparatus shown in Figure 2, and a number of light-sensitive plates were subjected to development processing.

A glass cell for measuring conductivity (type: CG-201PL, produced by Toa Denpa Co.) was attached to the development tank in the above described automatic development apparatus so that the conductivity of the developing solution in the development tank could be continually measured. A signal from the cell was sent to the body of the conductometer (CM-30ET, produced by Toa Denpa Co.) which connected with a sensor switch. When the conductivity was above 7.5 ms/cm, the switch was automatically operated to operate a supplying apparatus, by which 0.5 ℓ of water was added by a timer switch.

Using this automatic development apparatus, the above described imagewise exposed PS plates having a size of 1003 mm × 800 mm and a thickness of 0.30 mm was processed at a rate of 20 m²/day to carry out running of 160 m² per month at intervals of 3 - 4 days. The processing time per day was 5 hours. 270 mℓ of a

developing solution was supplied every 1 m$^2$ in addition to the supply of water to prevent inferior development.

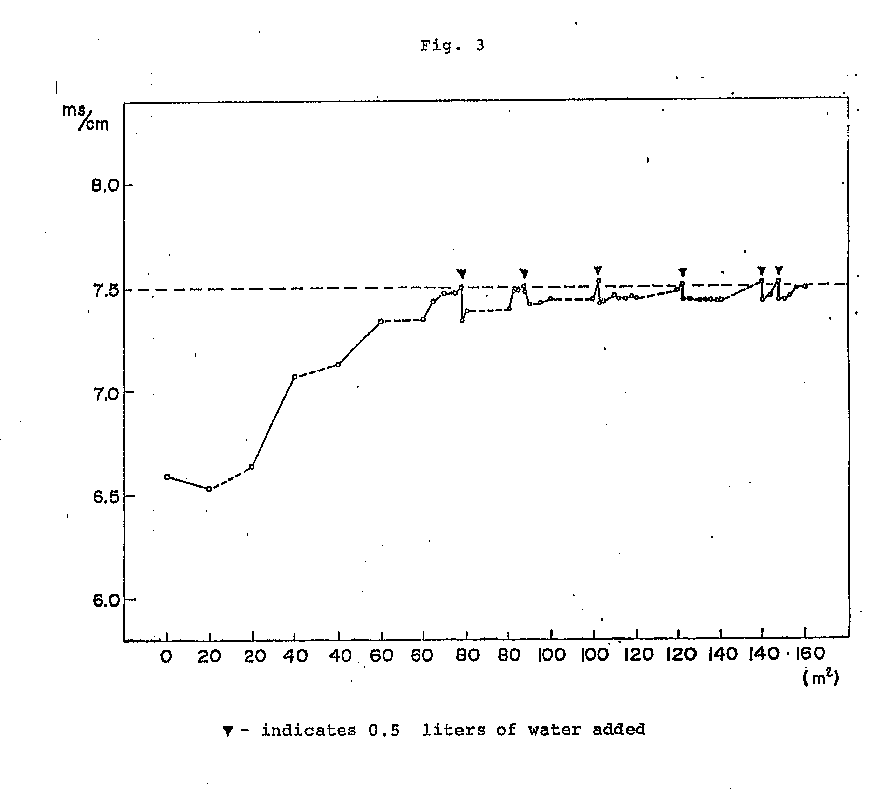

Changes of conductivity during this process are shown in Figure 3. The conductivity increased as the number of days of processing increased. When the conductivity reached the control value, 0.5 ℓ of water was supplied. The water was supplied 6 times during 1 month to supply 3.0 ℓ of water per month. In the planographic printing plates obtained by the above described development processing, adhesion of development sediments was not observed and stains did not occur in printing and good printing ability was obtained. When the same development processing was carried out as described above except that water was not supplied for comparison, when 100 m$^2$ of PS plates was processed, formation of development sediments was observed in the development tank, and the development sediments adhered to nonimage parts of the planographic printing plates. When printing was carried out practically using such plates, parts where the sediments adhered caused stains.

CLAIMS:

1.  A method of developing light-sensitive planographic printing plates, which comprises developing imagewise exposed light-sensitive planographic printing plates in a recycled aqueous developing solution containing inorganic ions while continually determining the conductivity of the developing solution and automatically adding a diluent to the developing solution when the conductivity has been determined to have reached a value beyond a fixed range in order to maintain the conductivity of the developing solution.

2.  A method as in claim 1, wherein the conductivity is maintained such that it does not exceed 1.3 times the starting conductivity of the developing solution.

3.  A method as in claim 1 or 2, wherein the developing solution is an aqueous solution containing 70 to 98% by weight water and inorganic ions.

4.  A method as in claim 3, wherein the developing solution is an aqueous solution comprising water, inorganic ion, organic solvent, alkali agent, and surface active agent.

5.  A method as in claim 4, wherein the organic solvent is selected from ethylene glycol monophenyl ether and benzyl alcohol, the alkali agent is an organic alkali agent, and the surface active agent is an anionic surfactant having an aromatic sulfonic acid group.

6.  A method as in any of claims 1 to 5, wherein the diluent is selected from water or an aqueous solution containing at least one component composing the aqueous developing solution.

7.  An apparatus for developing light-sensitive planographic printing plates, comprising:

   a means for providing a developing solution onto
   surfaces of exposed light-sensitive planographic
   printing plates;

   a means for collecting and recycling the developing
   solution;

   a means for continually measuring the conductivity
   of the developing solution;  and

   a means for automatically adding diluent to the
   developing solution which operates by an output
   signal from the conductivity measuring means in
   order to maintain the conductivity of the developing solution within a fixed range.

8. An apparatus as in claim 7, wherein the means for continually measuring the conductivity of the developing
   solution is an electromagnetic induction type meter.

9. An apparatus as in claim 8, wherein the meter is a
   conductometer having a temperature compensation circuit
   of plus or minus 2% per °C.

10. An apparatus as in any of claims 7 to 9, wherein the
    developing solution is an aqueous solution containing
    70  to 98% by weight water and containing inorganic
    ions.

11. An apparatus as in any of claims 7 to 10, further comprising a means for supplying a development supplement
    solution.

Fig. 1

Fig. 2

Fig. 3

▼ - indicates 0.5 liters of water added